# EUROPEAN PATENT APPLICATION

(11) **EP 3 772 822 A1**
(43) Date of publication of application: **10.02.2021**
(21) Application number: 19190019.0
(22) Date of filing: 05.08.2019
(51) Int. Cl.: H03K 17/14, G05F 3/26, G05F 1/46

(54) **CONSTANT CURRENT DRIVER DEVICE**

(71) Applicant: Alder Optomechanical Corp., 324 Taoyuan City (TW)
(72) Inventor: Budnik, Norbert Georg, 71522 Backnang (DE)
(74) Representative: John, Stefano Pasquale

(57) **Abstract**

The constant current driver device disclosed herein includes a first transistor adapted to receive an input source and a second transistor electrically connected to the first transistor. The invention is characterized in that the first transistor starts to work in cut-off region as the input source supplies an input voltage rising to a predetermined level during a voltage cycle, and the second transistor is so electrically connected to the first transistor that the second transistor starts to work in saturation region when its gate-source voltage (V_{GS}) is substantially greater than its threshold voltage (Vₜₕ) and its gate-drain voltage (V_{GD}) is substantially smaller than the Vₜₕ, thereby generating a constant current. The constant current driver device is capable of generating a stable current and remaining operating at high efficiency with low loss over a wide temperature range and over a wide voltage range.

## Description

### BACKGROUND OF THE INVENTION

### Field of the Invention

The present invention relates to a constant current driver device which can provide constant-current output and remain operating at high efficiency with low loss over a wide operating temperature range and over a wide input voltage range.

### Description of Related Art

Light-emitting diodes (abbreviated hereafter as LEDs) are a type of luminous semiconductor electronic elements which emerged as early as 1962. They can only emit red light with low brightness in the early days and were later on developed to function as a light source for emitting other types of monochromatic light. Nowadays, LEDs are available in many wavelengths for emitting visible light, infrared light and ultraviolet light, and the brightness thereof has been raised to a relatively high degree. Initially, LEDs were only used in indicator lights and display panels, etc. With the emergence of white light LEDs, the applications of LEDs to a variety of lighting devices have become increasingly widespread. For example, high-brightness LEDs have been widely used in traffic lights, vehicle indicator lights, and brake lights. In recent years, lighting devices provided with high-voltage LED light bars have been developed to replace conventional incandescent light bulbs and fluorescent light bulbs.

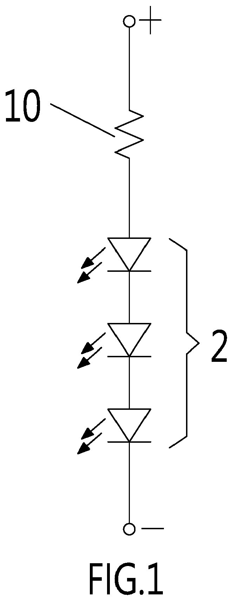

Fig. 1 show a conventional LED driver circuit, which includes at least one resistor 10 coupled in series between two serially connected circuits of LEDs 2. The voltage difference is compensated by the resistor 10, so that the input voltage is made in conformity with the series voltage of the LEDs 2. However, this circuit exhibits poor power conversion efficiency.

### SUMMARY OF THE INVENTION

In view of the above, an object of the invention is to provide a constant current driver device which can provide constant-current output and keep operating at high efficiency with low loss over a wide operating temperature range and over a wide input voltage range.

The constant current driver device disclosed herein involves circuitry for constant-current supply to a non-linear load with low operating voltage with smallest possible insertion losses in the range of threshold voltage, with low temperature dependence and low dependence of the predetermined operating current. The device further involves collaboration of a first transistor and a second transistor, and the two transistors are electrically connected to each other in such a way that the current measurement in the collector line of the first transistor is measured in front of the load, and that this measuring voltage is kept small in order to achieve low loss by provision of the second transistor in the emitter-base circuit of the first transistor.

The constant current driver device disclosed herein comprises a first transistor adapted to receive a DC-rising current (DC) input source and a second transistor electrically connected to the first transistor. The invention is characterized in that the first transistor starts to work in cut-off region as the DC input source supplies an input voltage rising to a predetermined level during a voltage cycle, and the second transistor is electrically connected to the first transistor that the second transistor starts to work in saturation region when its gate-source voltage (V_{GS}) is substantially greater than its threshold voltage (Vₜₕ) and its gate-drain voltage (V_{GD}) is substantially smaller than the Vₜₕ, thereby generating a constant current.

In a preferred embodiment, the first transistor is electrically connected at its emitter terminal to the input source, and the second transistor is electrically connected at its drain terminal to the input source, and wherein the first transistor is electrically connected at its collector terminal to the gate terminal of the second transistor, while the second transistor is grounded at its source terminal to a ground terminal.

In a preferred embodiment, the constant current driver device further comprises a first voltage dividing module comprising a first voltage dividing component and a second voltage dividing component connected in series and adapted to supplying a divided voltage to a base terminal of the first transistor.

In a preferred embodiment, the constant current driver device further comprises a first resistor connected in parallel with the second transistor and connected in series with second voltage dividing component.

In a preferred embodiment, the constant current driver device further comprises a Zener diode connected in series with the first voltage dividing module, whereas a voltage dividing point constituted between the Zener diode and the second voltage dividing component is connected to the base terminal.

In a preferred embodiment, the constant current driver device further comprises a second voltage dividing module comprising a third voltage dividing component and a fourth voltage dividing component connected in series and adapted to supply a divided voltage to the emitter terminal.

In a preferred embodiment, the constant current driver device further comprises a second resistor coupled between the ground terminal and the gate terminal.

In a preferred embodiment, the constant current driver device further comprises a third resistor coupled between the input source and the emitter terminal.

In a preferred embodiment, the first voltage dividing component has a resistance value substantially greater than that of the third resistor.

In a preferred embodiment, the constant current is supplied to a light-emitting diode or a string of light-emitting diodes.

In a preferred embodiment, the first transistor is selected from the group consisting of a bipolar transistor and a field-effect transistor.

### BRIEF DESCRIPTION OF THE DRAWINGS

The above and other objects, features and effects of the invention will become apparent with reference to the following description of the preferred embodiments taken in conjunction with the accompanying drawings, in which:
Fig.1 is a schematic diagram of the first conventional LED driver circuit;
Fig.2 is a schematic diagram of a constant current driver device according to the first embodiment of the invention;
Fig.3 is a schematic diagram of a constant current driver device according to the second embodiment of the invention;
Figs.4 (A)∼(C) show the curves of current against voltage obtained by the invention and the first conventional driver circuit at three different operation temperatures;
Fig.5 is a schematic diagram of a constant current driver device according to the third embodiment of the invention;
Fig.6 is a schematic diagram of a constant current driver device according to the fourth embodiment of the invention; and
Fig.7 is a schematic diagram of a constant current driver device according to the fifth embodiment of the invention.

### DETAILED DESCRIPTION OF THE PREFERRED EMBODIMENTS

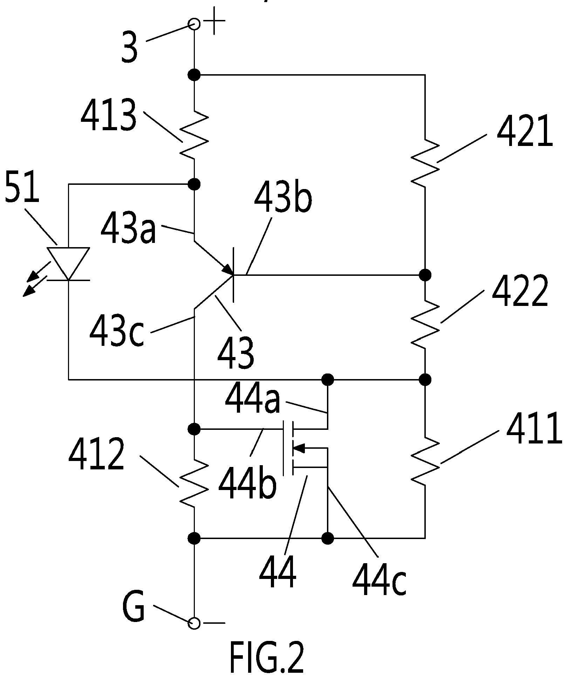

Fig.2 is a schematic diagram showing the constant current driver device according to the first preferred embodiment of the invention. As shown, a first transistor 43 is adapted to receive an increasing current input source 3. The first transistor 43 is electrically connected at its emitter terminal 43a to the input source 3, and the second transistor 44 is electrically connected at its drain terminal 44a to the input source 3. The first transistor 43 is electrically connected at its collector terminal 43c to the gate terminal 44b of the second transistor 44, whereas the second transistor 44 is grounded at its source terminal 44c to a ground terminal G.

During a voltage cycle of the input source 3, the first transistor 43 serves as a switch depending on the voltage level of the input source 3 applied. When the input voltage gradually rises from zero to a predetermined level, the first transistor 43 works in its cut-off region. At this time, if the potential difference between the gate terminal 44b and the source terminal 44c of the second transistor 44 (V_{GS}) is substantially greater than the threshold voltage (Vₜₕ) of the second transistor 44, and the potential difference between the gate terminal 44b and the drain terminal 44a of the second transistor 44 (V_{GD}) is substantially smaller than the Vₜₕ, then the second transistor 44 would start to work in its saturation region. As a result, a constant current output is generated, and low loss and high operation efficiency are achieved over a wide operating temperature range and over a wide input voltage range.

As shown in Fig.2, the constant current driver device according to the first preferred embodiment of the invention further comprises a first voltage dividing module, a first resistor 411 and a second resistor 412, and a third resistor 413.

The first voltage dividing module comprises a first voltage dividing component 421 and a second voltage dividing component 422. The first voltage dividing component 421 is connected at its one end to the input source 3 in parallel with the third resistor 413. The second voltage dividing component 422 is connected at its one end to the other end of the first voltage dividing component 421. In this embodiment, while the first voltage dividing component 421 and the second voltage dividing component 422 may by way of example be a resistor shown in Fig.2, respectively, it is apparent to those skilled in the art that a variable resistor is also applicable. The resistance value of the first voltage dividing component 421 is substantially greater than that of the third resistor 411. A reference voltage is generated at the voltage dividing point between the first voltage dividing component 421 and the second voltage dividing component 422 and provided at the base terminal 43b.

The second resistor 412 is connected at its one end to the collector terminal 43c and connected at the other end to the ground terminal G. The first resistor 411 is connected in parallel with the second transistor 44 and connected at one end to the second voltage dividing component 422 and connected at the other end to the ground terminal G. The third resistor 413 is connected at one end to the input source 3. The first resistor 411, the second resistor 412 and the third resistor 413 may independently be a resistor or a variable resistor. While referenced in this embodiment as a resistor for illustration purpose, it is apparent to those skilled in the art that the first resistor 411, the second resistor 412 and the third resistor 413 may independently be a resistor or a variable resistor.

In some embodiments, the first transistor 43 is selected from the group consisting of a bipolar transistor and a field-effect transistor. As shown in Fig.2, the first transistor 43 may by way of example be configured as a PNP bipolar junction transistor. In alternative embodiments, the first transistor 43 may be an NPN bipolar junction transistor, instead of a PNP bipolar junction transistor. The second transistor 44 may be configured in the form of a MOSFET, such as an NMOS transistor. In alternative embodiments, the second transistor 44 may be configured in the form of a PMOS transistor.

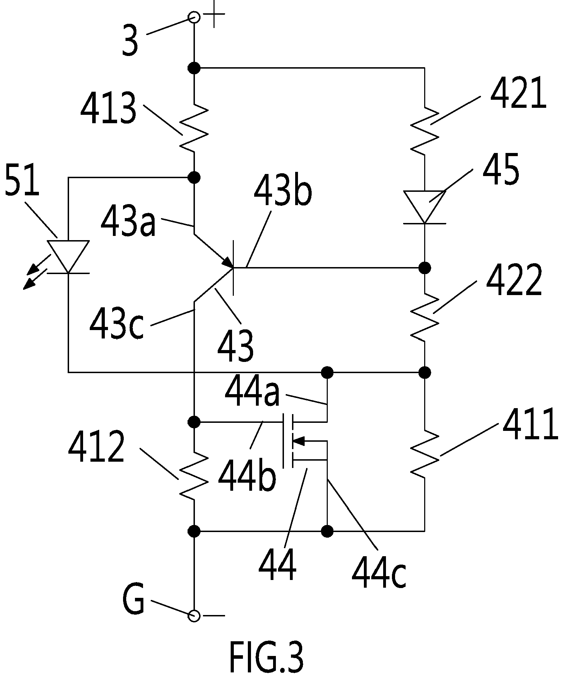

Furthermore, according to the second preferred embodiment shown in Fig.3, the device disclosed herein may further comprise a Zener diode 45 coupled between the first voltage dividing component 421 and the second voltage dividing component 422 of the first voltage dividing module. The voltage dividing point between the Zener diode 45 and the second voltage dividing component 422 is connected to the base terminal 43b.

The constant current driver device disclosed herein is adapted for use with a constant current device or an equipment (*i.e*., a load). In other words, the constant current driver device disclosed herein is adapted to drive a load, and the load may be either a single LED or a string of multiple LEDs. The constant current driver device is capable of outputting a stable and constant current to allow the LED module to emit light with stable brightness. In other applications of the invention, the load may include, but be not limited to, a LED device (such as a LED lamp), a battery charger and a power supply.

The operation of the constant current driver device disclosed herein will be further described as follows. In this embodiment, the constant current driver device is applied to drive a first LED module 51. The first LED module 51 includes an anode terminal coupled between the other end of the third resistor 413 and the emitter terminal 43a, and a cathode terminal connected to the drain terminal 44a. During normal operation, as soon as the operating voltage has exceeded at least the threshold voltage of approximately 0.6V between the base terminal 43b and the emitter terminal 43a after switching ON, an initially very low current flows through the second voltage dividing component 422 and the first resistor 411 via the base terminal 43b to the emitter terminal 43a of the transistor 43 and the third resistor 413 to the positive pole of the circuit arrangement. In parallel, part of the current flows through the Zener diode 45 and the first voltage dividing component 421 with higher resistance.

As soon as the current at the collector terminal 43c (amplified by the current amplification factor) of the transistor 43 has exceeded a voltage drop at the second resistor 412 of approximately 1V to 2V (the gate terminal 44b- the source terminal 44c voltage threshold of the transistor 44), it also begins to conduct in parallel to the first resistor 411). After the operating voltage has increased above approximately 3V (the current via the second voltage dividing component 422 is approximately 1mA), the voltage applied to the first LED module 51 reaches approximately 2.6V and it starts to light up due to the slowly increasing current. Very quickly, the LED current rises through the transistor 44 and generates a correspondingly increasing voltage drop at the third resistor 413 with low resistance. Since the U-I characteristic of the transistor 43 corresponds approximately to that of the Zener diode 45 with the same semiconductor material (both silicon), the first voltage dividing component 421 drops approximately the same voltage as at the third resistor 413. The burning voltage of the first LED module 51 comes quickly with increasing current in the steep area of their U-I characteristic and the voltage drop at the third resistor 413 increases strongly disproportionately.

Regarding the generation of a steady current, as soon as the voltage drop across the third resistor 413 rises to the same value as across the first voltage dividing component 421, the voltage difference between the base terminal 43b and the emitter terminal 43a of the transistor 43 is limited and the voltage drop at the second resistor 412, which has hitherto grown with the operating voltage, can no longer continue to grow. The I-U characteristic of the first LED module 51 thus becomes the reference voltage of the current limit of the constant current driver device. The circuit controls the use of current limiting as a function of the consumer's specimen parameters (LED) and not dependent on an external reference voltage.

Regarding the control of temperature compensation, the temperature coefficients TK of the threshold voltage (about 5mV/K) of the Zener diode 45 and transistor 43 are equal and compensate each other. The low TK of the first LED module 51 burning voltage (about 2mV/K) is compensated by the opposite drift in temperature with the increasing light output.

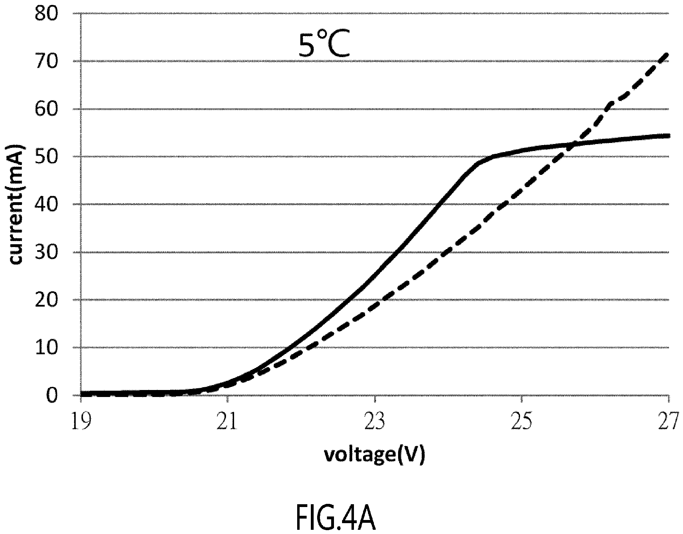

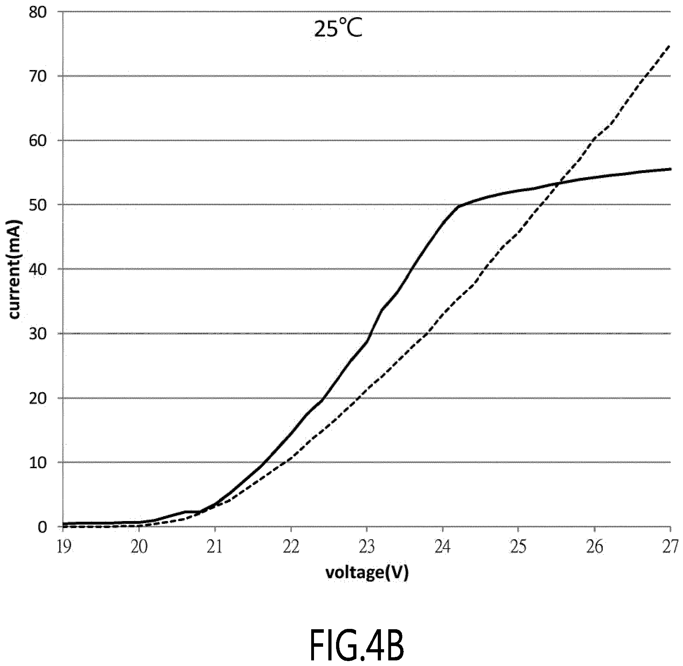

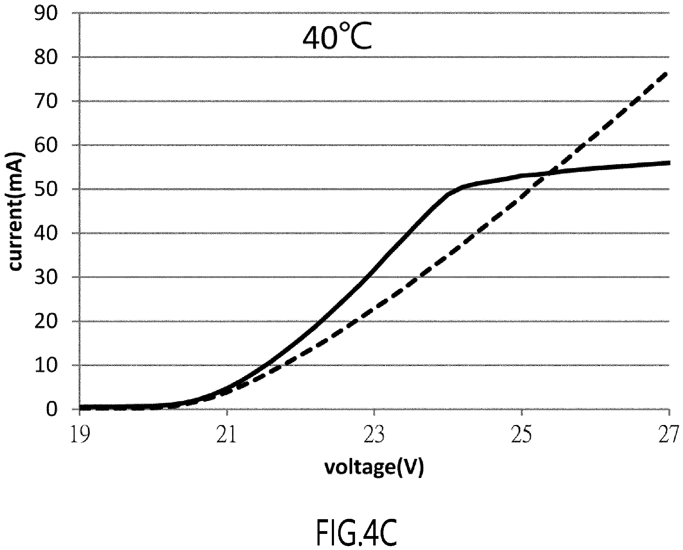

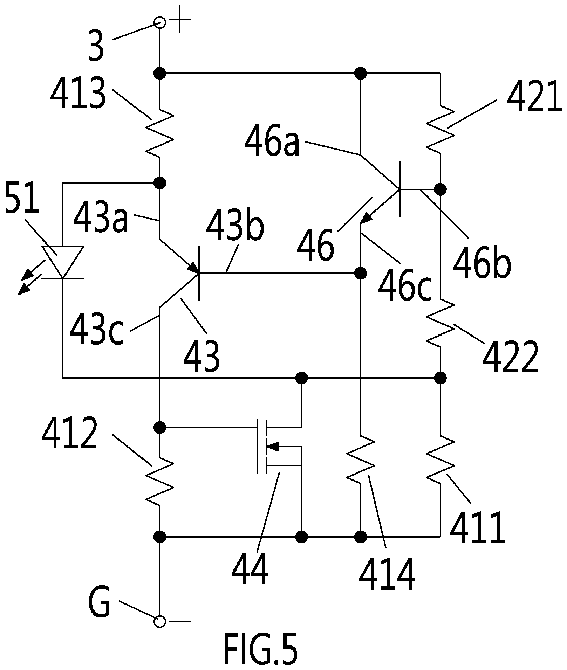

Figs.4(A)∼(C) show the curves of current against voltage as obtained by the invention and the first conventional driver circuit at three different operating temperatures. The solid lines shown in the figures indicate the curve obtained by the invention at the operating temperatures of 5°C, 25°C and 40°C, whereas the dotted lines are the curves obtained by the first conventional driver circuit at the same operating temperatures. It is clearly shown in Figs. 5(A)∼(C) that the invention achieves a stable and constant current output as the input voltage is gradually increased.

In addition, the third preferred embodiment shown in Fig.5 further includes a first control component 46 and a fourth resistor 414. The first control component 46 has a collector terminal 46a, a base terminal 46b and an emitter terminal 46c. The collector terminal 46a of the first control component 46 is connected to the input source 3 in parallel with the one end of the first voltage dividing component 421. The base terminal 46b of the first control component 46 is connected between the other end of the first voltage dividing component 421 and the one end of the second voltage dividing component 422. The emitter terminal 46c of the first control component 46 is connected to the base terminal 43b of the transistor 43. The fourth resistor 414 is connected at its one end to the emitter terminal 46c of the first control component 46 and coupled at the other end between the other end of the third resistor 413 and the source terminal 44c. In some embodiments, as shown in Fig.5, the first control component 46 may be configured in the form of an NPN bipolar junction transistor. In other embodiments, the third control component 46 may be configured in the form of a PNP bipolar junction transistor, rather than an NPN bipolar junction transistor. The fourth resistor 414 may be a fixed resistor or a variable resistor.

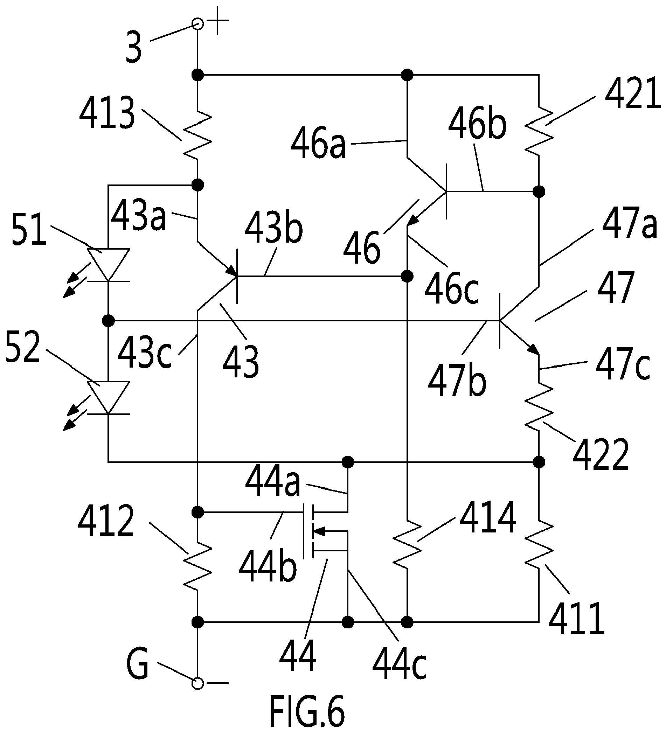

In the fourth embodiment shown in Fig.6, the constant current driver device is adapted to drive a first LED module 51 and a second LED module 52, and the first LED module 51 and second LED module 52 are connected in series with each other. The anode terminal of the first LED module 51 is connected between the third resistor 413 and the emitter terminal 43a of the first transistor 43. The cathode terminal of the second LED module 52 is connected to the drain terminal 44a of the second transistor 44. The device disclosed herein further comprises a second control component 47 coupled between the first voltage dividing component 421 and the second voltage dividing component 422. The second control component 47 includes a collector terminal 47a, a base terminal 47b and an emitter terminal 47c. The collector terminal 47a is connected to the other end of the first voltage dividing component 421. The base terminal 47b is coupled between the first LED module 51 and the second LED module 52. The emitter terminal 47c is connected to the one end of the second voltage dividing component 422. In the embodiment shown in Fig.6, the second control component 47 may be an NPN bipolar junction transistor. In other embodiments, the second control component 47 may be a PNP bipolar junction transistor, rather than an NPN bipolar junction transistor.

In the fourth embodiment shown in Fig.6, the second voltage dividing component 422, the second resistor 412 and the fourth resistor 414 may be configured in the form of a resistor with a resistance value of around 10K, allowing the first transistor 43, the third control component 46 and the second control component 47 to operate in the saturation region. The second transistor 44 is a key component that controls the current passing through the first LED module 51 and the second LED module 52. When the second transistor 44 is operated in the active region, the current flows from the drain terminal to the source terminal via the switch. There exists an internal resistance between the drain terminal and the source terminal, which is called as on-resistance RDS (ON). At this time, the second transistor 44 acts like a variable resistor whose resistance value is determined by its own RDS (ON) and varies significantly with temperature. The power consumption of the component can be calculated by Ids × RDS (ON). Since the on-resistance changes with temperature, the power consumption will change proportionally. The higher the voltage VGS applied to the second transistor 44, the lower the RDS (ON) will be. Conversely, the higher the RDS (ON) will be.

When the input voltage of the input source 3 is elevated (for example, from 19V to 28V), initially the current flowing through the first LED module 51 and the second LED module 52 increases, the Vds is elevated at the second transistor 44, and the Vbe is slightly lowered at the second control component 47. After the Vbe is lowered at the second control component 47, the cross-voltage at the first voltage dividing component 421 decreases. Subsequently, Vbe is elevated at the third control component 46, Ice increases at the third control component 46, and the cross-voltage at the fourth resistor 414 increases, thus leading to a decrease in Vbe at the first transistor 43 and a reduction of Ice at the first transistor 43. Eventually, the cross-voltage at the second resistor 412 decreases, resulting in a rapid rise of RDS (ON) at the second transistor 44, thereby promptly suppressing the current from flowing to the first LED module 51 and the second LED module 52. On the contrary, if the input voltage is reduced from 28V to 19V, RDS (ON) decreases rapidly at the second transistor 44, and the current of the first LED module 51 and second LED module 52 is elevated instantaneously. Finally, a static equilibrium point is reached. After careful adjustment, the resistance value of the second resistor 412 can control the current flowing through the first LED module 51 and the second LED module 52.

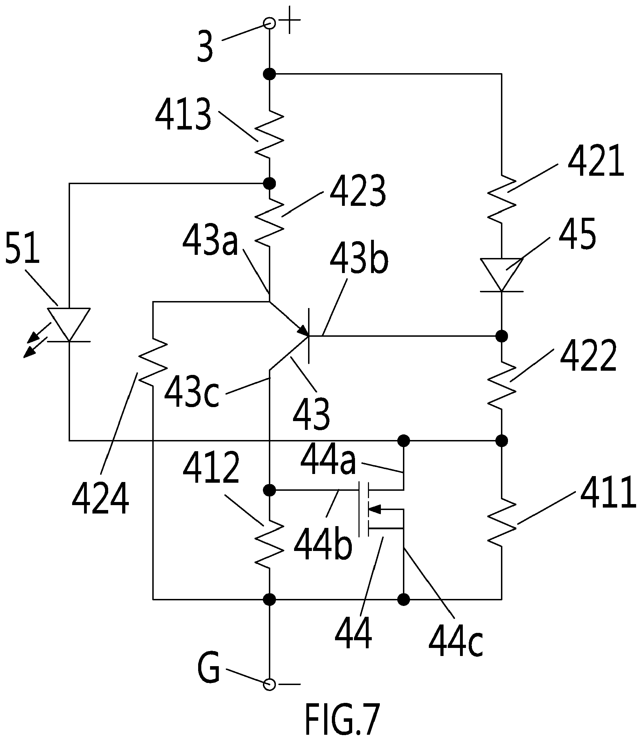

According to the fourth embodiment shown in Fig.7, the constant current driver device further comprises a second voltage dividing module adapted to supply a divided voltage to the emitter terminal 43a. The second voltage dividing module comprises a third voltage dividing component 423 and a fourth voltage dividing component 424 connected in series, which forms a voltage divider with the voltage drop across the supply transistor and largely linearizes the constant current of the overall circuit in dependence from the total operating voltage.

While the invention has been described with reference to the preferred embodiments above, it should be recognized that the preferred embodiments are given for the purpose of illustration only and are not intended to limit the scope of the present invention and that various modifications and changes, which will be apparent to those skilled in the relevant art, may be made without departing from the spirit and scope of the invention.

## Claims

1. A constant current driver device comprising:
a first transistor **43** adapted to receive an increasing current input source **3** and a second transistor **44** electrically connected to the first transistor **43**;
**characterized in that**:
the first transistor **43** starts to work in cut-off region as the increasing current input source **3** supplies an input voltage rising to a predetermined level during a voltage cycle, and the second transistor **44** is so electrically connected to the first transistor **43** that the second transistor **44** starts to work in saturation region when its gate-source voltage (V_{GS}) is substantially greater than its threshold voltage (Vₜₕ) and its gate-drain voltage (V_{GD}) is substantially smaller than the Vₜₕ, thereby generating a constant current.

2. The constant current driver device according to Claim 1, wherein the first transistor **43** is electrically connected at its emitter terminal **43a** to the input source **3**, and the second transistor **44** is electrically connected at its drain terminal **44a** to the input source **3**, and wherein the first transistor **43** is electrically connected at its collector terminal **43c** to the gate terminal **44b** of the second transistor **44**, while the second transistor **44** is grounded at its source terminal **44c** to a ground terminal **G**.

3. The constant current driver device according to anyone of the preceding Claims, further comprising a first voltage dividing module comprising a first voltage dividing component **421** and a second voltage dividing component **422** connected in series and adapted to supplying a divided voltage to a base terminal **43b** of the first transistor **43**.

4. The constant current driver device according to anyone of the preceding Claims, further comprising a first resistor **411** connected in parallel with the second transistor **44** and connected in series with second voltage dividing component **422.**

5. The constant current driver device according to anyone of the preceding Claims, further comprising a Zener diode **45** connected in series with the first voltage dividing module, and wherein a voltage dividing point constituted between the Zener diode **45** and the second voltage dividing component **422** is connected to the base terminal **43b.**

6. The constant current driver device according to anyone of the preceding Claims, further comprising a second voltage dividing module comprising a third voltage dividing component **423** and a fourth voltage dividing component **424** connected in series and adapted to supply a divided voltage to the emitter terminal **43a.**

7. The constant current driver device according to anyone of the preceding Claims, further comprising a second resistor **412** coupled between the ground terminal **G** and the gate terminal **44b.**

8. The constant current driver device according to anyone of the preceding Claims, further comprising a third resistor **413** coupled between the input source **3** and the emitter terminal **43a.**

9. The constant current driver device according to anyone of the preceding Claims, wherein the first voltage dividing component **421** has a resistance value substantially greater than that of the third resistor **413.**

10. The constant current driver device according to anyone of the preceding Claims, wherein the constant current is supplied to a light-emitting diode or a string of light-emitting diodes.

11. The constant current driver device according to anyone of the preceding Claims, wherein the first transistor **43** is selected from the group consisting of a bipolar transistor and a field-effect transistor.
